# EUROPEAN PATENT APPLICATION

(11) **EP 1 648 024 A1**
(43) Date of publication of application: **19.04.2006**
(21) Application number: 04105068.3
(22) Date of filing: 15.10.2004
(51) Int. Cl.: H01L 21/306

(54) **Method for removing particles from a surface**

(71) Applicant: SEZ AG, 9500 Villach (AT)
(72) Inventor: Pfeuffer, Alexander, 9500, Villach (AT)
(74) Representative: Kontrus, Gerhard

(57) **Abstract**

Method for cleaning a surface is disclosed comprising a cleaning step with an aqueous cleaning solution comprising nitrogen containing cations, selected from the group of ammonium ions and primary, secondary and tertiary ammonium ions, the pH-value of said solution is below 9 wherein mechanical agitation is applied to the particle for at least part of the time during the cleaning step.

## Description

The invention relates to a method for removing particles from a surface. Methods for removing particles from a surface are typically used in semiconductor industry for cleaning silicon wafer during production processes (e.g. pre photo clean, post CMP-cleaning, post plasma cleaning). However, such a cleaning method may be applied for other plate-like articles such as compact discs, photo masks, reticles, magnetic discs or flat panel displays. When used in semiconductor industry it may also be applied for glass substrates (e.g. in silicon-on-insulator processes), III-V substrates (e.g. GaAs) or any other substrate or carrier used for producing integrated circuits.

In semiconductor industry particle removal from silicon wafer is performed by mixtures of deionised water (DI), hydrogen peroxide, ammonia water (e.g. 5:2:1 to 50:2:1), the so-called "Standard Clean #1 (SC1)". Hydrogen peroxide is provided as aqueous solution with a concentration of 31 wt.%. Ammonia water (ammoniac) is provided as aqueous solution of ammoniac with a concentration of 28 wt.%. Because the chemical equilibrium of the dissociation

NH₃ + H₂O → NH₄⁺ + OH⁻ (pKb = 4,75)

is located on the left side, ammoniac acts not as a strong base. Only a small proportion of ammoniac reacts with water and therefore, the concentration of ammonium ions in SC1 is much smaller than the analytical ammonia concentration of ammoniac entered to the SC1. In the case of a mixture of deionised water (DI), hydrogen peroxide, ammonia water of 5:2:1 the ammonium cation concentration ([NH₄⁺]) is about 0,006 mol/l.

The cleaning mechanism of SC1 comprises two major steps. The first step is etching of silicone dioxide, which is a natural passivation layer on silicon (e.g. called native oxide). The second step is repulsion of loosened particles and surface from each other.

The native oxide layer on top of the silicon wafer is slowly etched at high pH above 7 due to hydroxide ions. A significant etch rate starts at a pH above 10. This causes under-etching of particles attached to the native oxide wafer surface. The hydrogen peroxide oxidizes silicon to silicon dioxide, renews hereby the oxide layer and thus protects the bulk material of the wafer from uncontrolled etching by hydroxide ions.

The surface charge of immersed surfaces depends strongly on the pH-value of the liquid. At high pH (above 10) the surface charge for most materials is negative. This results in repulsion of the particle away from the surface after the particles have lost direct contact with the surface (e.g. by substrate etching).

The major disadvantage of SC1 is that the surface of the substrate is etched. It is not desired any more by semiconductor industry that substrates are etched during cleaning. Layers on a substrate shall no longer be thinned by cleaning.

It is an object of the invention to provide a particle removal process, which substantially avoids any corrosion or any material loss, when it is applied. A further object of the invention is to provide a method, which avoids the use of any costly or environmental harmful chemicals.

The invention meets the objects by providing a method for cleaning a surface of a plate like article the method comprising a cleaning step with an aqueous cleaning solution wherein the solution comprises nitrogen containing cations, selected from the group of ammonium ions and primary, secondary and tertiary ammonium ions, the pH-value of said solution is below 9 and mechanical agitation is applied to the particle for at least part of the time during the cleaning step.

In other words the cleaning solution shall comprise ammonium ions of the structure (NHR₁R₂R₃)⁺, wherein the groups R₁, R₂, R₃ are selected from H (hydrogen) or any organic group. Preferably the organic group is selected from hydrocarbons such as alkyl groups (preferably methyl or ethyl).

In a preferred embodiment all groups are hydrogen resulting in NH₄⁺ (ammonium cation as such), which is advantageous because it is the less expensive compound and as an inorganic compound the easiest to dispose.

The cleaning solution can be applied to the surface either by dispensing the solution onto the surface or by immersion of the plate like article into the cleaning solution. Mechanical agitation to the particle can be applied either by agitating the liquid (e.g. stirring, fast flow parallel to the surface, spouting droplets against the surface, ultrasonic energy) or agitating the surface (e.g. shaking the article, applying ultrasonic energy to the article). Although not preferred, particles can be directly agitated through a solid material (e.g. a brush, a wiper, a scrubber, a scraper).

Surprisingly by using such a method particles could be sufficiently removed from a surface (e.g. a semiconductor wafer). Despite all prior theories it was even possible to remove particles with positive zeta potentials (charge of particle) from surfaces with negative zeta potential. Thus by using this cleaning method it can be avoided to use highly basic cleaning solutions (e.g. SC1), which had given the disadvantage of significantly affecting a surface (e.g. etching silicon dioxide surface of a semiconductor wafer).

The method according to the invention further avoids micro-roughening of the wafer surface, because of the low hydroxide ion concentration. Silicate formation is suppressed and the appearance of watermarks is reduced. No hydrogen peroxide is needed for protecting the wafer from being etched by hydroxide ions. For being an oxide-loss free cleaning method thin gate oxides stay intact.

In a preferred embodiment of the method the cleaning solution shall have a pH-value above 2. Advantageously the pH-value of the cleaning solution is above 3. Such method is advantageous if the surface is silicon dioxide because the point of zero charge for silicon dioxide is at pH 2-3. This is because in a preferred method, said solution shall have a pH-value above the point of zero charge (pzc) at least for the particle material or for the surface material and the pH-value is below 7 wherein mechanical agitation is applied to the particle. However if particles and or surfaces consist of other materials different lower limits of pH-value may apply. Several pH values for points of zero charge (pzc) for different materials are listed below:

silicon dioxide: 2-3

silicon nitride: 8-9

aluminium oxide: 8-9

magnesium oxide: 12

titanium oxide: 6

In another embodiment the agitation applied to the particle is applied through agitation of the liquid.

Such agitation of the liquid can be selected from the group comprising ultrasonic energy, applying accelerated droplets, dispensing a continuous liquid beam, rotating the plate like article, flowing across the surface of a plate like article at a flow sufficient fast to generate a mean velocity v parallel to the surface of a plate like article of minimum 0.1 m/s. Another possibility of agitation of the liquid is by light i.e. small vapour bubbles (micro bubbles) are generated by laser light in close proximity (distance < 1µm) to the respective particle and thereby inducing a micro shockwave.

When applying ultrasonic energy a frequency of above 500 kHz (megasonic) or higher is preferred (preferably > 1 MHz).

Applying accelerated droplets can be done with an apparatus as disclosed in US4787404.

Flowing the cleaning solution across the surface of a plate like article at a flow sufficient fast to generate a mean velocity v parallel to the surface of a plate like article of minimum 0.1 m/s (preferably minimum 0.5m/s) can be done by dispensing liquid at said velocity e.g. with a spin processor as disclosed in US 4903717. The dispensed liquid is redirected from the angle of impact into a flow parallel to the wafer surface without losing its velocity v.

Advantageously said solution has a pH-value below 8 (preferably below 7) for further reducing the amount of silicon dioxide etching in comparison to high pH SC1 solutions.

If the pH-value is selected below 5.5, silicon dioxide etching is reduced even more and as an additional benefit metallic contaminants are starting to be removed, which could eliminate an additional acid process step, therefore reducing overall process time as well as providing savings in chemical costs.

Good cleaning results could be achieved if the analytical concentration of ammonium ions calculated as [NHR₁R₂R₃]⁺ (e.g. NH₄⁺) is at least 0.01 mol per litre.

In another embodiment the cleaning solution includes anions deriving from an acid with a pKa-value below 4 for adjusting pH-value. (e.g. selected from the group nitrate, sulphate, chloride, bromide, perchlorate, chlorate, sulphite, formate, phosphate, iodate, hydrogen sulphate. These anions contain no metallic elements, which can cause severe problems during semiconductor manufacturing).

Yet another embodiment of the method uses a cleaning solution wherein the analytical concentration of fluoride ions calculated as F⁻ is below 0.001 mol per litre (preferably below 0.00001 mol per litre). A very low content of fluoride ions avoids the attack of the surface especially if it consists of silicon dioxide.

Advantageously said cleaning solution further comprises an oxidizing agent (preferably hydrogen peroxide or ozone). Preferred concentration of the oxidizing agent is 10 ppm to 10 wt.% (more preferably 100 ppm to 1%). Oxidizing agents are used for removal of organic contaminants and acts as an oxygen reservoir, which supports bubble formation (cavitation) during megasonic cleaning. For enhancing the oxygen generation by decomposition of the oxidizing agent a catalyst can be added to the cleaning solution (e.g. I⁻ ion for hydrogen peroxide, Cl⁻ ion for ozone).

Another embodiment of the method uses a cleaning solution which further comprises a wetting agent (preferably 2-propanol or acetone). This leads to a faster wetting of the article surface, which further leads to a shorter process time. Preferred concentration of the surfactant is 10 ppm to 1wt.% (more preferably 100 ppm to 0,1 %).

Although the surface of the plate-like article can be directly dried (e.g. through IPA (2-propanol) assisted drying) after applying the cleaning step the method preferably comprises a subsequent rinsing step.

For sublimating possible traces of remained ammonia salts (e.g. NH₄Cl) a short-time heating step (e.g. 350°C for NH₄Cl) can be applied.

Further details and advantages of the invented method will become apparent by the examples below.

Example A: Ammonium chloride solution with a concentration of 1 mol per litre is provided in a cleaning bath at 30°C. Such a solution has a pH of 4.6. Silicon wafer with a silicon dioxide surface is immersed into the cleaning bath and megasonic energy (ultrasonic energy at above 1 MHz, e.g. 1500 kHz) is applied trough a plurality of transducers, which are attached to the cleaning bath. A high purity ammonium chloride solution can be made by equimolarly mixing ammonia and hydrochloric acid. After the cleaning step the wafer is submerged into DI-Water for rinsing followed by a drying step.

Example B: Based on example A but with a 10 times diluted cleaning solution. The ammonium chloride concentration of 0.1 mol per litre leads to a pH of 5.1.

Both embodiments (examples A, B) lead to perfect cleaning efficiency (over 99% particles could be removed) and no detectable etch rate of the substrate.

Example C: Ammonium chloride solution with a concentration of 0.1 mol per litre is dispensed onto a rotating (300 rpm) silicon wafer with a silicon dioxide surface at 20°C for 0.5 minutes. The flow rate is 0.5 l/min and the flow velocity 1 m/s. Thereafter the wafer is rinsed and dried.

Example D: Same as example C however 50 ppm 2-propanol is added to the solution as a surfactant (time of the process step 20 sec).

Table 1 shows cleaning efficiency and etch rate of substrate dependent on pH-value in cleaning solutions comprising ammonium ions when mechanical agitation is applied. Mechanical agitation is applied through a transducer plate in close proximity (gap of approximately 2 mm) to the wafer surface. The gap between the wafer and the transducer plate was filled with an aqueous solution comprising ammonium ions with a concentration of 0.2 mol per litre. Concentration and pH value were adjusted by mixing the appropriate amount of ammonia, hydrochloric acid and deionised water.

**Table 1**

| **Ex. no.** | **pH-Value** | **substrate** | **particle** | **charge of substrate** | **charge of particle** | **cleaning efficienc y** | **etch rate substrate** |
|---|---|---|---|---|---|---|---|
| 1 | <2 | silicon dioxide | silicon nitride | pos. | pos. | moderat e | zero |
| 2 | 2-7 | silicon dioxide | silicon nitride | neg. | pos. | good | zero |
| 3 | 7-9 | silicon dioxide | silicon nitride | neg. | pos. | good | moderat e |
| 4 | >9 | silicon dioxide | silicon nitride | neg. | neg. | good | high |
| 5 | <2 | silicon dioxide | titan dioxide | pos. | pos. | moderate | zero |
| 6 | 2 - 6 | silicon dioxide | titan dioxide | neg. | pos. | good | zero |
| 7 | 6-7 | silicon dioxide | titan dioxide | neg. | neg. | good | zero |

| **Ex. no.** | **pH-Value** | **substrate** | **particle** | **charge of substrate** | **charge of particle** | **cleaning efficienc y** | **etch rate substrate** |
|---|---|---|---|---|---|---|---|
| 8 | 7-9 | silicon dioxide | titan dioxide | neg. | neg. | good | moderate |
| 9 | >9 | silicon dioxide | titan dioxide | neg. | neg. | good | high |

As can be seen in the list in contrast to previously used particle removing solutions (e.g. SC1) there is no necessity of charging the particles and the article surface to the same polarity when using the invented method. It is believed that it is only necessary to charge at least one of both the particle or the surface of the article negatively.

Without being bound to any theory it is believed that the cleaning method according to the invention consists of two major effects, which are mechanical impact and particle lift-off.

The mechanical impact reduces direct contact of particle and substrate. The occurrence of particle lift-off depends on the electrostatic forces between particle and substrate.

If particle and substrate are charged in the same way repulsive forces lead to immediate particle lift-off (e.g. example no. 1, 4, 5, 9 in Tab. 1).

If particle and substrate are charged in different ways attractive forces would prevent the particle from lift-off, if the mechanical force was not sufficient. Ammonium ions show an unknown special capability to penetrate the thin water layer between particle and substrate, even for different charged surfaces. The negative charged surface is shielded by the ammonium cation and particle lift-off can occur.

## Claims

1. Method for removing particles from a surface comprising a cleaning step with an aqueous cleaning solution wherein the cleaning solution comprises nitrogen containing cations, selected from the group of ammonium ions and primary, secondary and tertiary ammonium ions, the pH-value of said solution is below 9 and mechanical agitation is applied to the particles for at least part of the time during the cleaning step.

2. Method according to claim 1 wherein the nitrogen containing cations are ammonium ions.

3. Method according to claim 1 wherein said agitation applied to the particles is applied through agitation of the liquid.

4. Method according to claim 1 wherein the pH-value is above 2.

5. Method according to claim 3 wherein the pH-value is above 3.

6. Method according to claim 1 wherein the pH-value is below 8.

7. Method according to claim 5 wherein the pH-value is below 7.

8. Method according to claim 6 wherein the pH-value is below 5.5.

9. Method according to claim 1 wherein the analytical concentration of ammonium ions is at least 0.01 mol per litre.

10. Method according to claim 1 wherein said cleaning solution includes anions deriving from an acid with a pKa-value below 4.

11. Method according to claim 1 wherein the analytical concentration of fluoride ions calculated as F is below 0.001 mol per litre.

12. Method according to claim 1 wherein said cleaning solution further comprises an oxidizing agent (e.g. hydrogen peroxide, ozone).

13. Method according to claim 12 wherein said cleaning solution further comprises a wetting agent (e.g. 2-propanol, acetone).

14. Method according to claim 12 further comprising a subsequent rinsing step.
